# EUROPEAN PATENT APPLICATION

(11) **EP 2 273 613 A1**
(43) Date of publication of application: **12.01.2011**
(21) Application number: 09164749.5
(22) Date of filing: 07.07.2009
(51) Int. Cl.: H01Q 1/52, H01F 17/00, H01F 27/36

(54) **Magnetic shield layout, semiconductor device and application**

(71) Applicant: NXP B.V., 5656 AG Eindhoven (NL)
(72) Inventor: Nazarian, Alexé Levan, 5656 AE, Eindhoven (NL); Tiemeijer, Lukas Frederik, 5656 AE, Eindhoven (NL)
(74) Representative: Krott, Michel

(57) **Abstract**

Magnetic shield layout (10,10A-10G) arranged for an integrated circuit of a semiconductor device comprising a first inductor (1) having a first inductor-area (11), and a second inductor (2) having a second inductor-area (12), wherein the inductor-areas (11,12) are located in an inductor-plane (P) and wherein the first and second inductors (1,2) in operation are subject to an induction coupling; a magnetic shield (20) for reducing the induction coupling, said magnetic shield having a conductive path (21) marking a first shield-area (13) assigned to the first inductor-area (11) and a second shield-area (14) assigned to the second inductor-area (12); wherein the shield-areas (13,14) are conductively and continuously connected by the conductive path (21) such that in operation a magnetic field generated by the first inductor (1) is largely cancelled by the magnetic field of the second shield-area (12) and/or a magnetic field generated by the second inductor (2) is largely cancelled by the magnetic field of the first shield-area (11).

## Description

### FIELD OF THE INVENTION

The present invention relates to a magnetic shield layout arranged for an integrated circuit of a semiconductor device comprising: at least a first inductor having a first cross-sectional inductor area and at least a second inductor having a second cross-sectional inductor area, wherein the inductor areas are located in an inductor plane and wherein the first and second inductors in operation are subject to an induction coupling; at least one magnetic shield for reducing the induction coupling, said magnetic shield having a conductive path marking a first cross-sectional shield area assigned to the first cross-sectional inductor area and a second cross-sectional shield area assigned to the second cross-sectional inductor area. The invention further relates to a semiconductor device and an application.

### BACKGROUND OF THE INVENTION

IC inductors as mentioned in the introduction are in particular essential to realize voltage controlled oscillators needed in the many fully integrated transceiver chips. The required inductance value is typical a few nH and should be adjustable to the application, whereas the quality factor should be as high as possible. An additional benefit could be a low net magnetic field, resulting in a lower magnetic coupling to other inductors. These and other objects have been addressed by special inductor layouts as disclosed in WO 1998/005048 A1, WO 2004/012213 A1, WO 2005/096328 Al or WO 2006/105184A1. These so-called low magnetic field inductors described therein, nevertheless, are still subject to undesired magnetic coupling between different inductors on a chip and can result in malfunctioning of a circuit. A particular disadvantage of the low magnetic field inductors as for instance proposed in WO 2004/012213 A1 and WO 2005/096328 Al is their decreased quality factor (Q), which reduction may amount to 30 % - 50 %. Desirable, therefore, is an improved shielding of inductors which is adapted for implementation into an integrated circuit of a semiconductor device.

From the principles of electromagnetics, it is known generally that it is possible to shield antenna arrangements. Principles for instance have been applied in magnetic resonance devices, one of these is for instance disclosed in US 2004/0124840 A1. These and other resonance imaging systems, like for instance the one described in JP 2008-067733A, are specifically adapted for resonance examination of specific organs or body parts of a patient, wherein surface antennas are increasingly used to receive resonance signals from the body of the patient. However, the teaching disclosed therein and magnetic layouts thereof cannot be transferred or implemented in an integrated circuit of a semiconductor device.

This is where the invention comes in, the object of which is to provide a magnetic shield layout arranged for an integrated circuit of a semiconductor device, a semiconductor device and an application, wherein an induction coupling of a first and second inductor in operation are shielded and a magnetic shield is of increased effect and can easily be implemented into an integrated circuit of a semiconductor device.

### SUMMARY OF THE INVENTION

As regards the magnetic shield layout, the object is achieved by the magnetic shield layout arranged for an integrated circuit of a semiconductor device as mentioned in the introduction, wherein, in accordance with the invention, it is proposed that the shield areas are conductively and continuously connected by the conductive path such that, in operation, a magnetic field generated by the first inductor is largely cancelled by the magnetic field of the second cross-sectional shield area and/or a magnetic field generated by the second inductor is largely cancelled by the magnetic field of the first cross-sectional shield area. Thereby the induction coupling of the first and second inductor is reduced, respectively cancelled.

As regards the semiconductor device, the object is achieved by a semiconductor device comprising a magnetic shield according to the invention. In particular, the semiconductor device is in form of an integrated circuit, particularly an integrated circuit in the form of a transmitting device having a transmit module and an oscillator module, wherein each module has an inductor area and a shield area of the magnetic shield layout. Such kind of integrated circuits are realized for instance in the form of integrated transceiver chips or the like.

Of course, the magnetic shield layout and developed configurations thereof as outlined above may be implemented by digital circuits of any preferred kind, whereby the advantages associated with the digital circuits may be obtained. A semi-conductor processor or other units may fulfill the functions of several means recited in the claims. A digital circuit or processor of the mentioned kind may be implemented in one or more multiprocessor systems.

The object with regard to the application is achieved by an application comprising a semiconductor device according to the invention and/or a magnetic shield layout according to the invention. Applications of a preferred kind are realized for instance in a remote access vehicle, a wireless LAN, a Bluetooth system or other systems.

In its basic idea, the present invention is directed to a very effective magnetic shield layout arranged for implementation into an integrated circuit of a semiconductor device in a particular easy way. Thereby, the disadvantages as known from principle applications of electromagnetics are avoided. It has been realized that above objects can be attained particular easy in an integrated circuit by continuously connecting the shield areas of the magnetic shield by a continuous conductive path.

Developed configurations of the invention are further outlined in the dependent claims.

A particular advantageous configuration is realized by a magnetic shield layout, wherein the conductive path of the magnetic shield is in the form of an 8-shape forming the cross-sectional first and second shield areas, each having an eye. In such a 8-shapedmagnetic shield, it is of particular importance that, in a conductive connection of the shield areas, the conductive path has crossing-over path tracks. Consequently, the shield areas thereof are conductively connected by the conductive path such that a conductive direction of the path in the first shield area is counter-rotating to a conductive direction of the path in the second shield area. It has been found that this configuration is overwhelmingly efficient for cancelling the magnetic field of an inductor by the magnetic field of the assigned shield area. In particular, it has been found that this configuration offers a way to shield inductors from each other, independent of the distance between these inductors, and also offers less than 20 % of decrease in the Q-factor. In particular preferred embodiments, the Q-factor decrease may be in the range of below 10 %, typical 5 to 8 %, advantageous 6 to 7 %.

This advantage can be essential for a semiconductor device, in particular in the form a preferred kind of integrated transceiver chip. Therein, usually first and second inductors are IC inductors of separate and different purpose and, nevertheless, part of an undesired induction-coupled arrangement, for instance in an arrangement of an integrated circuit with an integrated transceiver chip with a transmitting module and oscillator module of a transmitting device. The shielding of magnetic coupling, independent of the distance between the inductors with reduced decrease in Q-factor, therefore, is very welcome.

Generally, the 8-shape magnetic field can be positioned as desired. Particularly preferred is that the cross-sectional first shield area and the first cross-sectional inductor area have an aligned center and/or the cross-sectional second shield area and the second cross-sectional inductor area have an aligned center. In other words, the eyes of the 8-shape magnetic shield overlap at least partly with the cross-sectional inductor areas of the first and second inductor, respectively. For instance, a center of an eye is aligned with a center of a cross-sectional inductor area in a direction perpendicular to the inductor plane. It has been found, furthermore, of particular advantage that the assigned cross-sectional shield area and cross-sectional inductor area are geometrically similar, i.e. can be transformed into each other by a mathematical similarity transformation. For instance, a quadratic shape or octaeder shape or other polyeder or round shape form of an inductor area is geometrically similar to the assigned cross-sectional shield area of an 8-shape magnetic shield.

Further developed configurations of the invention are related to a particular preferred arrangement of the magnetic shield with regard to the inductor plane. It is particular preferred that the first and second inductors are planar and/or the inductor areas of the first and second inductor are located in the same inductor plane.

In a particular easy embodiment, a magnetic shield is provided with shield areas located in a plane different from the inductor plane, in particular above or below the inductor plane.

A particular preferred and developed magnetic shield layout is arranged such that either (a) a single magnetic shield is provided with the shield areas and the inductor areas located in the same inductor plane or (b) at least two magnetic shields are provided, wherein at least one thereof is provided with the shield areas located in a plane different from the inductor plane. In other words, either a single magnetic shield is provided in the inductor plane or two, three or more magnetic shields are provided, wherein at least one thereof is in a plane different from the inductor plane. It has been found surprisingly that this particular preferred embodiment provides superior results with regard to cancelling the magnetic field of the inductors.

Advantageously, at least two magnetic shields are provided and at least a first one thereof is provided with a shield area located in a plane different from the inductor plane, and a second one thereof is provided with a shield area and the inductor areas located in the same inductor plane.

Alternatively, however also advantageous, at least two magnetic shields are provided wherein all thereof are provided with the shield areas located in a plane different from the inductor plane.

Generally, the magnetic shield can be located in the inductor plane and/or located parallel orientated to the inductor plane at a distance, in particular above and/or below the inductor plane. Therein, of course, the inductor areas can be located in an inductor plane and the cross-sectional shield areas can be located parallel orientated to the inductor plane at a distance, wherein the distance preferably ranges from a value above 0 µm up to 200 µm, in particular up to 10 µm. Also preferably, the magnetic shield can be located parallel orientated to the inductor plane at a distance above and/or below the inductor plane and a distance below is different from a distance above.

The shield area itself of the magnetic shield can be equal or different in size. Also, the shield area may have an inner diameter of up to 1 mm and/or a width of conductive path of up to 50 µm.

Last but not least, it has been found that a magnetic shield is particular effective in an integrated circuit of a semiconductor device wherein the conductive path is free of reactive components. In particular, reactive components, like a capacitance, inductance or resistance, is advantageously prevented.

In particular it is preferred that the path is free of a resistance. As in case of a semiconductor device, in particular in an integrated circuit, each reactive component interrupting the path of the magnetic shield has a non-neglectable resistance, a reactive component is most preferably avoided. The avoidance of such or other reactive components helps to keep an advanced level of quality of the decoupled inductors.

Furthermore, it is preferred that the first shield area is assigned only to the first inductor area and that the second shield area is assigned only to the second inductor area. Geometrically, this configuration realizes a magnetic shield, wherein the first shield area preferably overlaps only with the first inductor area and the second shield area preferably overlaps only with the second inductor area.

### DETAILED DESCRIPTION OF THE INVENTION

These and other aspects of the invention will be apparent from and elucidated with reference to the embodiments described with the figures and examples hereinafter and which are not intended to limit the scope of the invention. In the claims, the word "comprising" does not exclude other elements or steps, and the indefinite article "a" or "an" does not exclude a plurality. The mere fact that certain measures are recited in mutually different dependent claims does not indicate that a combination of the measured cannot be used to advantage. Any reference signs in the claims should not be construed as limiting the scope. It is, of course, not possible to describe every conceivable configuration of the components or methodologies for purposes of describing the present invention, but one of ordinary skill in the art will recognize that many further combinations and permutations of the present invention are possible. Whereas the invention has particular utility for and will be described as associated with an integrated transceiver chip, it should be understood that the magnetic shield layout is also operable with other forms of integrated circuits. Further, the features described in the description, the drawings and the claims disclosing the invention, may be essential for the invention considered alone or in combination. The person skilled in the art will understand that various embodiments may be combined.

### BRIEF DESCRIPTION OF THE DRAWINGS

The drawing shows in:
Fig. 1: a plane view of two inductors and an 8-shape magnetic shield according to a preferred embodiment of a magnetic shield layout;

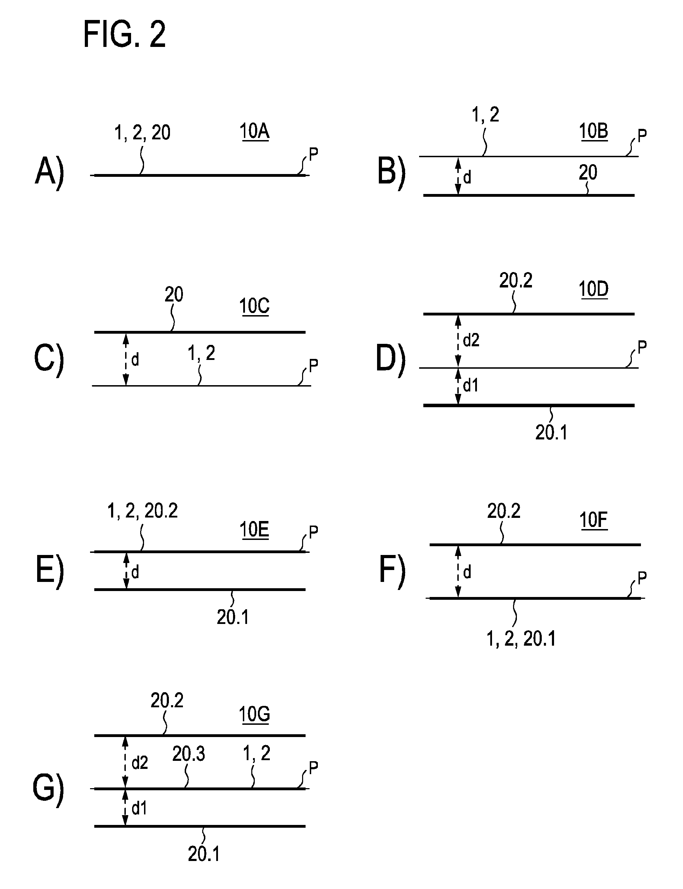

Fig. 2: magnetic shield arrangements with regard to an inductor plane of preferred embodiments of magnetic shield layouts (A - G), wherein in (A) inductors and magnetic shield share the same inductor plane; in (B), the magnetic shield lays below the inductor plane; in (C), the magnetic shield lays above the inductor plane; in (D), two magnetic shields are used, wherein one lays above and one below the inductor plane; in (E), one magnetic shield lays below the inductor plane and the other one on the same inductor plane; in (F), one magnetic shield lays above the inductor plane and the other one on the same inductor plane; in (G), three magnetic shields are used, wherein two magnetic shields lay above and below the inductor plane and the other one on the same inductor plane;
Fig. 3: an arrangement of a first inductor (aggressor on the left) and a second inductor (victim on the right) with the currents indicated by arrows;
Fig. 4: the inductor arrangement of Fig. 3 with a magnetic shield according to a preferred embodiment of a magnetic shield layout of the invention, wherein the first inductor induces current in the magnetic shield and the flux of the magnetic field produced by the first inductor is compensated by the flux of the magnetic field that is produced by the right part of the magnetic shield;
Fig. 5: the embodiment of Fig. 4 with degrees of freedom denoted by D₁, D₂, w₁ and w₂, which can be chosen to reduce magnetic coupling, i.e. minimize induced current in the second inductor;
Fig. 6: an exemplary study of remained induced current in the second inductor as a result of adding one (top curve) or two (bottom curve) 8-shape magnetic shields of the preferred embodiment. Therein, induced current in the unshielded second inductor (victim) is taken as 100 % and d is a distance between the first and second inductor in µm;
Fig. 7: an exemplary decline in quality factor as a result of adding one (bottom curve) or two (top curve) of 8-shape magnetic shields of the preferred embodiment. A quality factor of unshielded first inductor (aggressor) is taken as 100 % and d is a distance between the first and second inductor.

### DETAILED DESCRIPTION OF THE DRAWINGS

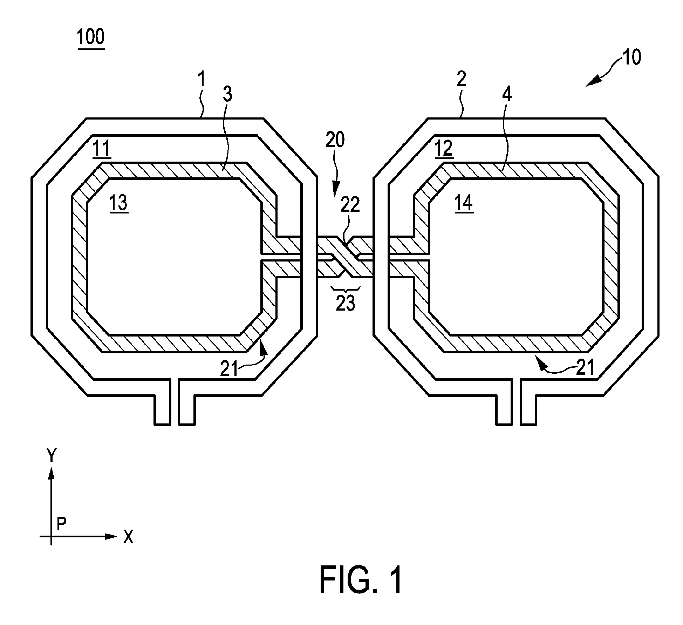

Fig. 1 shows the preferred kind of magnetic shield layout 10, which as such is arranged for an integrated circuit of a semiconductor device 100. The semiconductor device 100 is in the form of an integrated transceiver chip having a transmitting device with a transmit module and an oscillator module, wherein each module has an inductor area and a shield area of the magnetic shield layout 10.

The semiconductor device 100 can be part of an application, such as a remote access vehicle, a wireless LAN or Bluetooth, which is not shown in detail in the figure.

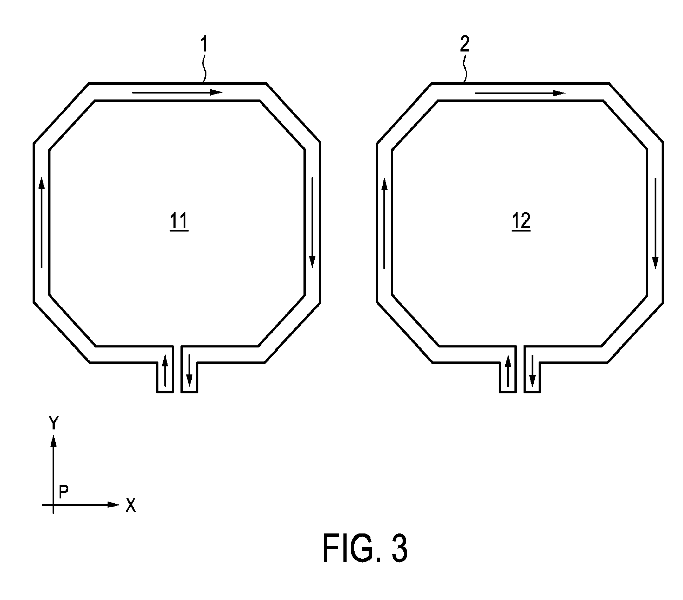

The magnetic shield layout 10 of the present embodiment has a first inductor 1 and a second inductor 2. The first inductor 1 has a first cross-sectional inductor area 11, and the second inductor has a second cross-sectional inductor area 12, wherein the inductor areas 11, 12 are located in an inductor plane P, which is symbolized in Fig. 1 with the axis of a coordinate system X, Y. Due to their neighborhood, the first and second inductors 1, 2 in operation are subject to an induction coupling induced by the magnetic flux of a magnetic field, which is flowing through both the first and second inductor area 11, 12. Indication is made to Fig. 3, which illustrates the effect of induced current, the latter is shown as arrows in the inductors 1, 2. Changing current in the first inductor - on the left hand side, also named aggressor inductor - generates a changing magnetic field. As it follows from the fundamental principles of electrodynamics, a changing flux of this magnetic field through the inductor area 12 of the second inductor 2 - inductor on the right hand side, also named victim inductor-generates induced current in the second inductor 2. Of course, the same principle acts vice versa with the second inductor as aggressor and the first inductor as victim inductor.

By adding at least one magnetic shield 20, the magnetic shield layout 10 of Fig. 1 is achieved. The magnetic shield 20 is for reducing the induction coupling, having a conductive path 21 which marks, in a first part 3, a first cross-sectional shield area 13 assigned to the first cross-sectional inductor area 11 and, in a second part 4, a second cross-sectional shield area 14 assigned to the second cross-sectional inductor area 12. Following the concept of the invention, the shield areas 13, 14 are conductively and continuously connected by the conductive path 21 such that, in operation, a magnetic field generated by the first inductor 1 is largely cancelled by the magnetic field of the second cross-sectional shield area 14. Vice versa, also a magnetic field generated by the second inductor 2 is largely cancelled by the magnetic field of the first cross-sectional shield area 13. In the present embodiment, this principle works independent of the distance between the inductors 1, 2 and pertains the Q-factor of the inductors 1, 2 on a high level.

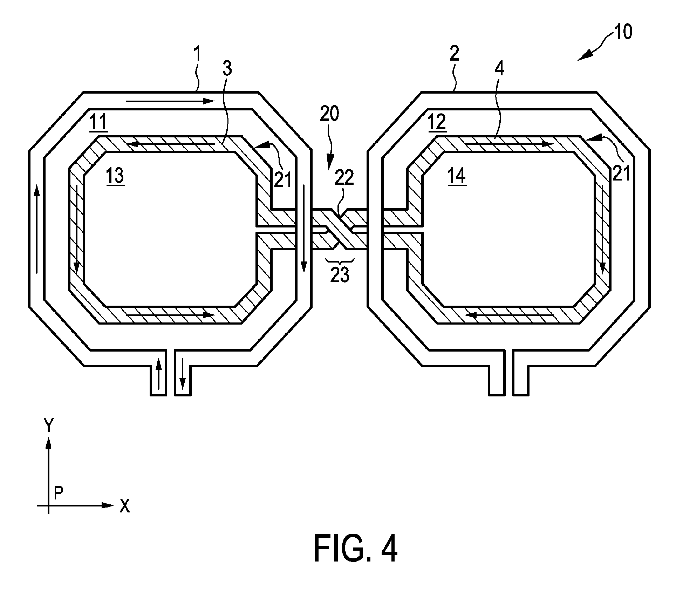

In particular, in this embodiment, the conductive path 21 of the magnetic shield 20 is in the form of an 8-shape forming the cross-sectional first and second shield areas 13, 14 - the shield areas 13, 14 each form an eye of the 8-shape. In this embodiment, the shield areas 13, 14 are conductively connected by the conductive path 21. As best shown in Fig. 4, the connection is such that a conductive direction of the path 21 (part 3) in the first shield area 13 is counter-rotating to a conductive direction of the path 21 (part 4) in the second shield area 14. This is achieved by a crossing-over 22 of path tracks in a conductive connection 23 of the shield areas 13, 14. The working principle is also best shown in Fig. 4. From the moment, the first inductor 1 induces current in the magnetic shield 20 (arrows) in the conductive path 21, the flux of the magnetic field of the first inductor through the second inductor 2 has opposite sign to the flux of the magnetic field of the shield 20. Thereby, the flux of the magnetic field produced by the first inductor 1 is compensated by the flux of the magnetic field that is produced by the second shield area 14 of the magnetic shield 20. In result, by conductively and continuously connecting the shield areas 13, 14 through the conductive path 21 in operation, a magnetic field generated by the first inductor 1 is largely cancelled by the magnetic field of the second cross-sectional shield area 14 and/or a magnetic field generated by the second inductor 2 is largely cancelled by the magnetic field of the first cross-sectional shield area 13.

In the present embodiment of Fig. 1, Fig. 4 and Fig. 5, the 8-shape magnetic shield 20 lays in the inductor plane P represented by the coordinate system X, Y. However, partial variations of these embodiments are possible, wherein in the 8-shape magnetic shield 20 always lays in a plane parallel to the inductor plane. These other embodiments are shown in Fig. 2. Therein, always eyes of the magnetic shield 20 are vertically aligned with the inductors, in other words, the shield areas 13, 14 and the inductor areas 11, 12 have an aligned center and overlap geometrically. Also, in these embodiments, the form of a shield area 13, 14 is similar to the form of an inductor area 11, 12. Here, the form with eight edges is used with four short tracks on the edges and four longer tracks on the sides of the shield areas 13, 14.
Fig. 2A shows a first embodiment of a magnetic shield layout 10A, wherein the inductors 1, 2 and the magnetic shield 20 share the same inductor plane. In other words, the shield areas 13, 14 and the inductor areas 11, 12 are located in the same inductor plane P.
Fig. 2B shows an embodiment of magnetic shield layout 10B, wherein the magnetic shield 20 lays below the inductors 1, 2. In other words, one magnetic shield 20 is provided with the shield areas 13, 14 located in a plane different from the inductor plane P. The same holds for the embodiment of magnetic shield layout 10C in Fig. 2C. In the embodiment 10B, the magnetic shield 20 lays below the inductors 1, 2. In the embodiment 10C, the magnetic shield 20 lays above the inductors 1, 2.
Fig. 2D shows an embodiment of magnetic shield layout 10D, wherein two magnetic shields 20.1, 20.2 are provided, wherein the shield areas thereof are located in a plane different from the inductor plane P. In the embodiment of magnetic shield layout 10D, both of the magnetic shields 20.1, 20.2, i.e. all the shield areas thereof, are located in a plane different from the inductor plane P. The distance d1 of magnetic shield 20.1 and d2 of magnetic shield 20.2 are chosen to be different in the present embodiment.

In Fig. 2F, a further embodiment of magnetic shield layout 10F is shown, wherein one magnetic shield 20.1 lays below the inductors 1, 2 and a further magnetic shield 20.2 lays in the inductor plane P. In other words, two magnetic shields 20.1, 20.2 are provided and at least a first one thereof 20.1 is provided with the shield areas located in a plane different - here below - from the inductor plane P, and a second one 20.2 thereof is provided with the shield areas and the inductor areas located in the same inductor plane P.

In Fig. 2F, an embodiment of magnetic shield layout 10F is shown, which follows the latter principle, however, the second magnetic shield 20.2 is located in a plane different - here above - from the inductor plane P and the first magnetic shield 20.1 is provided with the shield areas and the inductor areas located in the same inductor plane P.

In Fig. 2G, an embodiment of magnetic shield layout 10G is provided with three magnetic shields 20.1, 20.2 and 20.3, wherein two magnetic shields 20.1, 20.2 lay below and above the inductors 1, 2 in the inductor plane P. The distances d1, d2 between the inductor plane P and the planes of the magnetic shields 20.1, 20.2, respectively, are different in size. A further third magnetic shield 20.3 is located in the same plane as the inductors 1, 2, namely in the inductor plane P.

It has been found that each of the embodiments of magnetic shield layouts 10A-10G can be chosen on demand. For instance, placing an 8-shape magnetic shield above inductors 1, 2 in the inductor plane P, can be achieved by using a flip chip construction.

In each case of Fig. 2, an 8-shape magnetic shield 20, 20.1, 20.2, 20.3 significantly reduces eddy current in the victim inductor. The exact reduction depends on the production process. For example, in CMOS065, induced current will be reduced by factor 15 by one 8-shape magnetic shield and by a factor 20 by two magnetic shields.

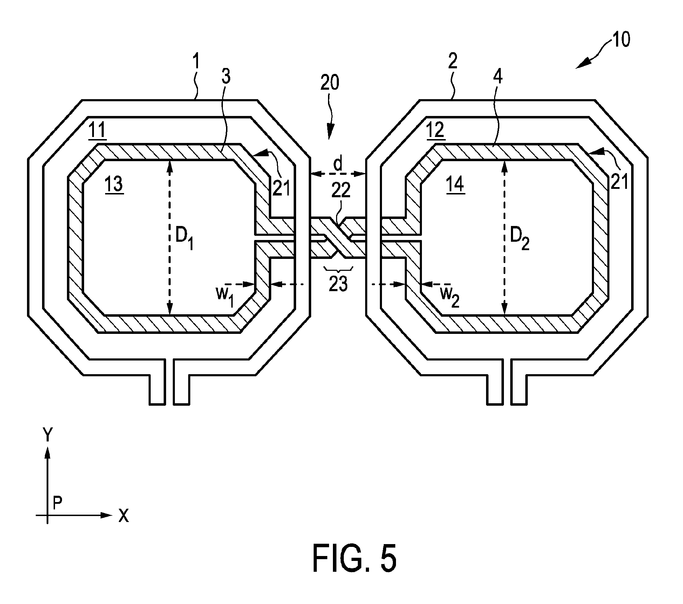

Also, one can chose the width and diameters of both parts of the magnetic shield in such a way that the total flux of the resulting magnetic shield through the victim inductor is kept minimal. The degrees of freedom are best shown in Fig. 5. Beside the plane of the magnetic shield and the numbers thereof as shown in Fig. 2 also the distance between the respective parts 3, 4 of the shield 20, the diameter D₁, D₂ of the shield areas 13, 14 and the width W1 and W2 of the path 21 can be chosen to minimize induced current in the victim inductor. This will imply minimum induced current in the victim inductor and, therefore, will shield the victim inductor from the aggressor inductor. However, also from the principles of electromagnetic, it is clear that current in the 8-shape magnetic shield is somewhat in retarded behind the current in the aggressor inductor. This is why complete cancellation of induced current in the victim inductor cannot be achieved. However, the best shielding result will be obtained by using magnetic shields with maximum quality factor.

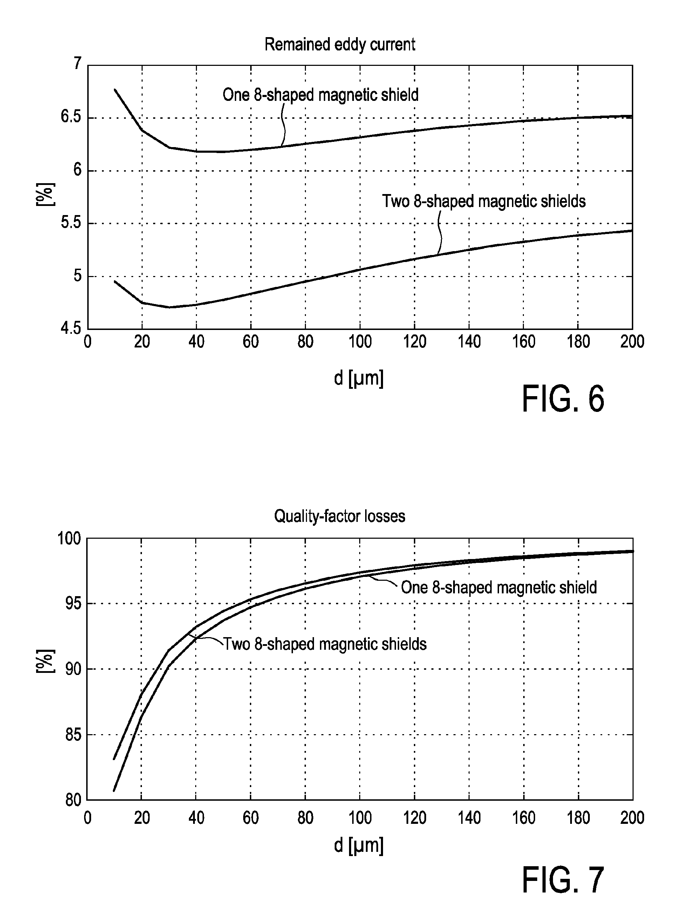

In order to demonstrate effectiveness of an 8-shape magnetic shield, the example of magnetic shield layout 10 in Fig. 5 has been chosen, wherein both inductors 1, 2 were chosen with inner diameter of 200 µm and width of the inductor track of 10 µm. Both inductors 1, 2 have one turn. Calculations have been made to determine the optimum dimensions of the 8-shape magnetic shield 20, wherein the optimum dimensions are defined by the degrees of freedom, namely the diameters D₁, D₂ and width of path w₁, w₂ of the shield areas 13, 14 defined by the conductive path 21 as shown in Fig. 5. The ratio of the induced current in the presence of the magnetic shield to the induced current without any shield has been calculated as well as a relative decline in quality factor of the aggressor inductor. All calculations were made using an approach described in the article of L. F. Tiemeijer, R. J. Havens, Y. B. Bouttement and H. J. Pranger named "Physics Based Wideband Predictive Compact Model for Inductors with HIFH Amounts of Dummy Metal Fill", published in "IEEE Transactions on Microwave Theory and Techniques", vol. 54, N8, 2006. The full disclosure of this article is implemented herein by reference. Results as a function of distance d - which is the distance between the inductors 1, 2 - are illustrated in Fig. 6 and Fig. 7. Fig. 6 shows the remained induced current in the victim inductor as a result of adding one or two 8-shape magnetic shields. Fig. 7 shows the decline in quality factor Q as a result of adding one or two 8-shaped magnetic shields.

In a summary, the concept of the instant invention - as shown by the preferred embodiments - achieves effective shielding of magnetic shields for inductors 1, 2 which are magnetically coupled and is implemented easily in an integrated circuit of a semiconductor device. The concept of the invention is, as mentioned before, applicable to any circuit where inductors magnetically interact with each other, for example, any transmitting module requires shielding between transmit stage and voltage-controlled oscillator. The applications could be remote access vehicle, wireless LAN or Bluetooth.

## Claims

1. Magnetic shield layout (10, 10 A - 10 G) arranged for an integrated circuit of a semiconductor device comprising:
- at least a first inductor (1) having a first crosssectional inductor-area (11), and
at least a second inductor (2) having a second crosssectional inductor-area (12), wherein the inductor-areas (11, 12) are located in an inductor-plane (P) and wherein
the first and second inductors (1, 2) in operation are subject to an induction coupling;
- at least one magnetic shield (20) for reducing the induction coupling, said magnetic shield having a conductive path (21) marking
a first crosssectional shield-area (13) assigned to the first cross-sectional inductor-area (11) and a second crosssectional shield-area (14) assigned to the second crosssectional inductor-area (12);
**characterized in that**
- the shield-areas (13, 14) are conductively and continuously connected by the conductive path (21) such that in operation
a magnetic field generated by the first inductor (1) is largely cancelled by the magnetic field of the second cross-sectional shield-area (12) and/or a magnetic field generated by the second inductor (2) is largely cancelled by the magnetic field of the first cross-sectional shield-area (11).

2. Magnetic shield layout (10, 10 A - 10 G) according to claim 1, wherein the conductive path (21) of the specific magnetic shield (20) is in the form of an 8-shape forming the crosssectional first and second shield-areas (13, 14) each having an eye.

3. Magnetic shield layout (10, 10 A - 10 G) according to claim 1 or 2, wherein
a magnetic shield (20) is provided with the shield-areas (13, 14) located in a plane different from the inductor-plane (P), in particular above or below the inductor plane (Fig. 2 B, Fig. 2 C).

4. Magnetic shield layout (10, 10 A - 10 G) according to any of claims 1 to 3, wherein
either a single magnetic shield (20) is provided with
the shield-areas (13, 14) and the inductor-areas (11, 12) located in the same inductor-plane (P) (Fig. 2 A)
or at least two magnetic shields (20.1, 20.2) -in particular two, three or more magnetic shields- are provided,
wherein at least one thereof is provided with
the shield-areas located in a plane different from the inductor-plane (P) (Fig. 2 D, Fig. 2 E, Fig. 2 F, Fig. 2 G).

5. Magnetic shield layout according to any of claims 1 to 4, wherein the first shield-area (13) is assigned only to the first inductor-area (11) and the second shield-area (14) is assigned only to the second inductor-area (12), in particular the first shield-area (13) overlaps only with the first inductor-area (11) and the second shield-area (14) overlaps only with the second inductor-area (14).

6. Magnetic shield layout (10, 10 A - 10 G) according to any of claims 1 to 5, wherein at least two magnetic shields (20.1, 20.2) are provided; and at least a first one thereof is provided with the shield-areas (13, 14) located in a plane different from the inductor-plane (P) and
a second one thereof is provided with the shield-areas (13, 14) and the inductor-areas (11, 12) located in the same inductor-plane (Fig. 2 E, Fig. 2 F, Fig. 2 G).

7. Magnetic shield layout (10, 10 A - 10 G) according to any of claims 1 to 6, wherein at least two magnetic shields (20.1, 20.2) are provided, wherein all thereof are provided with the shield-areas located in a plane different from the inductor-plane (P) (Fig. 2 D).

8. Magnetic shield layout (10, 10 A - 10 G) according to any of claims 1 to 7, wherein the inductor-areas (11, 12) are located in an inductor-plane (P) and the crosssectional shield-areas (13, 14) are located parallel orientated to the inductor-plane (P) at a distance (D), wherein the distance (D) ranges from a value above 0µm to 200µm, in particular above 0µm to 10µm

9. Magnetic shield layout (10, 10 A - 10 G) according to any of claims 1 to 8, wherein the magnetic shield (20) is located in the inductor-plane (P) and/or located parallel orientated to the inductor-plane at a distance, in particular above and/or below the inductor-plane.

10. Magnetic shield layout (10, 10 A - 10 G) according to any of claims 1 to 9,
wherein the magnetic shield (20) is located parallel orientated to the inductor-plane (P) at a distance above and/or below the inductor-plane and a distance (d1) below is different from a distance (d2) above.

11. Magnetic shield layout (10, 10 A - 10 G) according to any of claims 1 to 10,
wherein the conductive path (21) is free of reactive components, in particular free of resistive reactive components.

12. Magnetic shield layout (10, 10 A - 10 G) according to any of claims 1 to 11 wherein the shield-areas (13, 14) of the magnetic shield (20) are equal or different in size.

13. Magnetic shield layout (10, 10 A - 10 G) according to any of claims 1 to 12,
wherein the shield-areas (13, 14) have an inner diameter (D 1, D 2) of up to 1mm and/or a width (W 1, W 2) of conductive path (21) of up to 50µm

14. Semiconductor device (100), in particular an integrated circuit, comprising a magnetic shield layout (10, 10 A - 10 G) according to any of claims 1 to 13, in particular in the form of a transmitting device having a transmit module and an oscillator module each module having an inductor-area and a shield-area of the magnetic shield layout.

15. Application, such as remote access vehicle, wireless LAN, Bluetooth, comprising a semiconductor device (100) according to claim 14 and/or a magnetic shield layout (10, 10 A - 10 G) according to any of claims 1 to 13.
